# EUROPEAN PATENT SPECIFICATION

(11) **EP 1 251 510 B1**
(45) Date of publication and mention of the grant of the patent: **05.09.2007**
(21) Application number: 02250753.7
(22) Date of filing: 05.02.2002
(51) Int. Cl.: G11B 20/12, G11B 20/18, H03M 13/27

(54) **Optical information recording medium and data recording apparatus**
Optisches Informationsaufzeichnungsmedium und Datenaufzeichnungsgerät
Support d'enregistrement optique d'informations et appareil d'enregistrement de données

(30) Priority: 20.04.2001 KR 2001021521
(43) Date of publication of application: 23.10.2002
(60) Divisional application: 04017916.0
(73) Proprietor: SAMSUNG ELECTRONICS CO., LTD., Suwon-City, Kyungki-do (KR)
(72) Inventor: Hwang, Sung-hee, Gangnam-gu, Seoul (KR); Lee, Yoon-woo, Paldal-gu, Suwon-gi, Gyeonggi-do (KR); Han, Sung-hyu, Youngdeungpo-gu, Seoul (KR); Ryu, Sang-hyun, Paldal-gu, Suwon-si, Gyeonggi-do (KR)
(74) Representative: Robinson, Ian Michael

(56) References cited:
- EP-A- 0 729 151
- PATENT ABSTRACTS OF JAPAN vol. 2000, no. 05, 14 September 2000 (2000-09-14) -& JP 2000 057700 A (SAMSUNG ELECTRONICS CO LTD), 25 February 2000 (2000-02-25)
- PATENT ABSTRACTS OF JAPAN vol. 2000, no. 14, 5 March 2001 (2001-03-05) -& JP 2000 323995 A (TOSHIBA CORP), 24 November 2000 (2000-11-24)

## Description

The present invention relates to error correction, and more particularly, to an optical information recording medium, a data recording apparatus, and a data recording method used by the apparatus which are capable of recording high density data.

Digital broadcasting will soon be commonly used in many countries of the world. However, current digital versatile discs (DVDs) have a capacity of 4.7-10 gigabytes, and thus a two-hour movie (about 25 gigabytes) which is received via digital broadcasting cannot be recorded in a disc. As a result, a high density recording medium for recording a digital broadcast having the size of a movie is required.

A method for reducing the size of a laser beam used in recording/reading data is a representative example of a method for increasing recording density. The smaller the radius of the laser beam the more densely an information track in which data are recorded can be formed, thereby increasing recording density. However, if only the radius of the laser beam is decreased, the quantity of light used in recording/reading data is also reduced, and the effect caused by damage or dust occurring on the surface of the disc is relatively increased. That is, an error generation rate in recording/reading data is increased.

US 6539512B1 shows an interleaving method for a high density recording medium and an interleaving circuit therefore. In this circuit, an intrablock interleaver interleaves received data having a predetermined error correction code within an error correction block to output intrablock-interleaved data. An interblock interleaver interleaves the intrablock-interleaved data between the error correction blocks in units of a predetermined number of the error correction blocks to output interblock-interleaved data. This document forms the precharacterising portion of the claims appended hereto.

It is an aim of the present invention to provide an optical information recording medium, a data recording apparatus, and a data recording method used by the apparatus, which have higher error correction rates in recording/reading data.

It is a second aim of the present invention to provide an optical information recording medium, a data recording apparatus, and a data recording method used by the apparatus which are capable of searching main data at a high speed and have lower error rates.

It is a third aim of the present invention to provide an optical information recording medium, a data recording apparatus, and a data recording method used by the apparatus, which are compatible with the format of a conventional digital versatile disc (DVD) and have higher error correction rates.

According to the present invention there is provided an apparatus and method as set forth in the appended claims. Preferred features of the invention will be apparent from the dependent claims, and the description which follows.

For a better understanding of the invention, and to show how embodiments of the same may be carried into effect, reference will now be made, by way of example, to the accompanying diagrammatic drawings in which:
Figures 1A and 1B are block diagrams of a data recording apparatus according a preferred embodiment of the present invention;
Figures 2A and 2B illustrate the format of error correction code (ECC) blocks for interleaving according to the preferred embodiment of the present invention;
Figure 3 illustrates the format of a block generated by in-block interleaving of Figure 2A according to the preferred embodiment of the present invention;
Figure 4 illustrates the format of ECC blocks A and B for interleaving according to the present invention;
Figure 5 illustrates the format of a recording block according to the present invention;
Figure 6 is an example of the recording block generated by between-block interleaving of Figure 5 according to the present invention;
Figure 7 illustrates the largest error of a recording block according to the present invention that can be corrected by error correction according to the present invention;
Figure 8 illustrates the recording block in which the largest error occurs, rearranged on the basis of the ECC blocks A and B of Figure 7;
Figures 9A and 9B are block diagrams of a data reproducing apparatus according to the present invention; Figure 10 is a schematic flow chart illustrating a data recording method according to the present invention; and
Figure 11 is a flow chart illustrating a data recording method according to the preferred embodiment of the present invention.

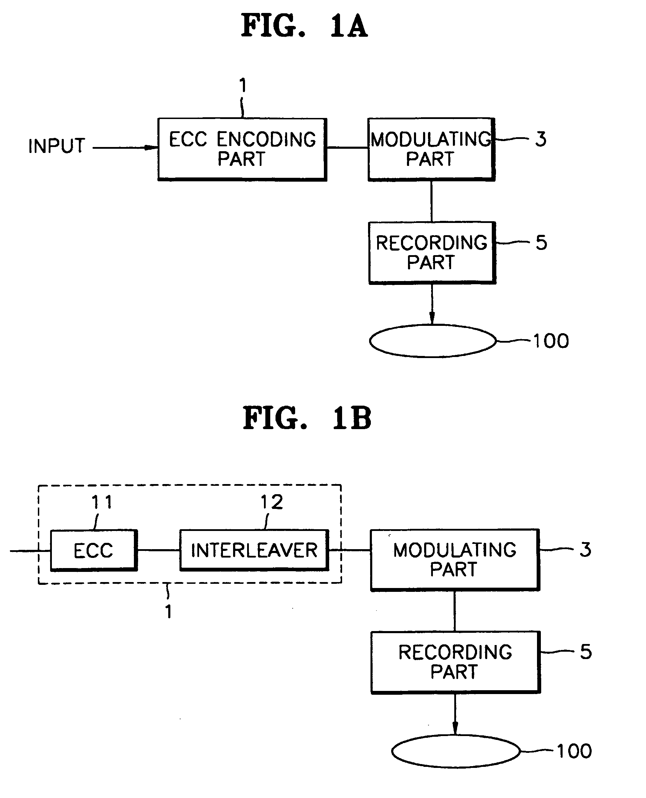

Figures 1A and 1B are block diagrams of a data recording apparatus according a preferred embodiment of the present invention. Referring to Figures 1A and 1B, the data recording apparatus includes an error correction code (ECC) encoding part 1, a modulating part 3, and a recording part 5. The ECC encoding part 1 includes an ECC encoder 11 and an interleaver 12. The ECC encoder 11 encodes main data with an error-correction-code (ECC). The interleaver 12 interleaves the ECC-encoded main data according to the present invention and generates a recording block. Interleaving is done to increase error correction efficiency and is a method for physically distributedly recording contiguous main data in ECC blocks on an optical disc. Burst error can be very effectively corrected by interleaving. A more specific interleaving method will be described later.

The modulating part 3 modulates the recording block generated by the ECC encoding part 1 according to a predetermined modulating method. The modulating method used in this embodiment is eight to fourteen modulation plus (EFM+), that is, a method for modulating each byte of the recording block data into a 16 bit code word. The recording part 5 records the modulated recording block on an optical disc 100. When recording the modulated recording block on the optical disc 100, a channel bit pulse stream which a modulated bit stream is converted into by non return to zero inversion (NRZI) coding according to the embodiment, is recorded. Here, various converting methods for recording the channel bit pulse stream can be used.

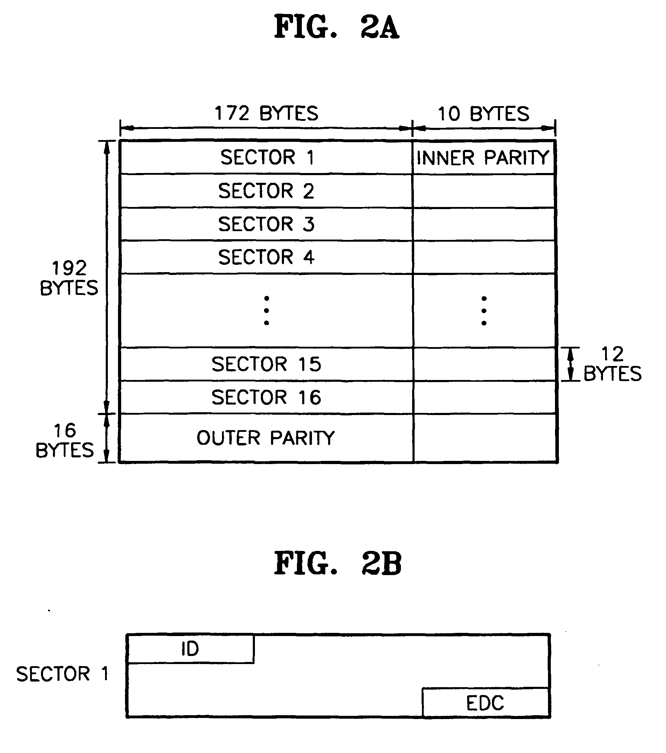

Figures 2A and 2B illustrate the format of error correction code (ECC) blocks for interleaving according to the preferred embodiment of the present invention. Referring to Figure 2A, the ECC blocks consist of 182 bytes of data in a row direction, and 208 bytes of data in a column direction. 172 byes of main data and 10 bytes of an inner parity of a row-code word are arranged in a row direction, and 16 sectors and 16 bytes of an outer parity are arranged in a column direction. 12 bytes of one sector is arranged in a column direction. The row-code words can be obtained by Reed-Solomon Product coding. That is, each row is a RS(182, 172, 11) code, and each column is a RS(208, 192, 17) code. Here, 182 and 208 are the total size of the code words, 172 and 192 are the size of the main data, and 11 and 17 are the number of parity bytes plus one byte. Since Reed-Solomon Product coding is good at correcting multi-errors and is used in digital versatile discs (DVD), in this embodiment, Reed-Solomon Product coding is selected for compatibility with DVDs. However, the coding method used can be changed when needed. Similarly, the size of the ECC blocks and the number of bytes allocated to the parity can be changed.

Referring to Figure 2B, 12 bytes of an identifier ID and 4 bytes of a parity for error detection and correction (EDC) are included in each sector. The address of the main data included in the corresponding sector is recorded in the identifier ID. Thus, the main data can be searched by the identifier ID.

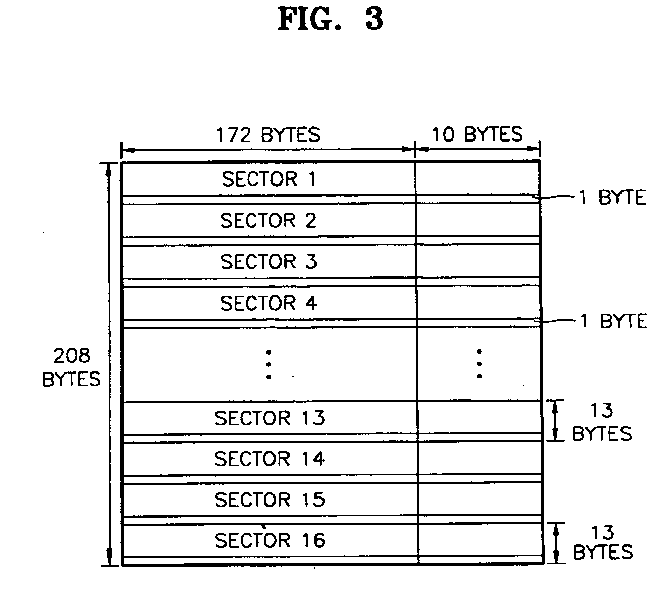

Figure 3 illustrates the format of a block generated by in-block interleaving of Figure 2A according to the preferred embodiment of the present invention. Referring to Figure 3, the ECC blocks are interleaved in the block according to the preferred embodiment of the present invention. In other words, 16 bytes of an outer parity is included at the end of each sector in units of one row in the same way as row-interleaving defined in a DVD format. As a result, many unbalances (caused by the difference of an outer parity block) occurring when the ECC blocks are recorded by the above method can be removed.

Interleaving in the block, i.e. "in-block interleaving" used in this embodiment is performed in consideration of interchangeability with a DVD and uniformity of data included in the ECC blocks, but may be not used as occasion demands.

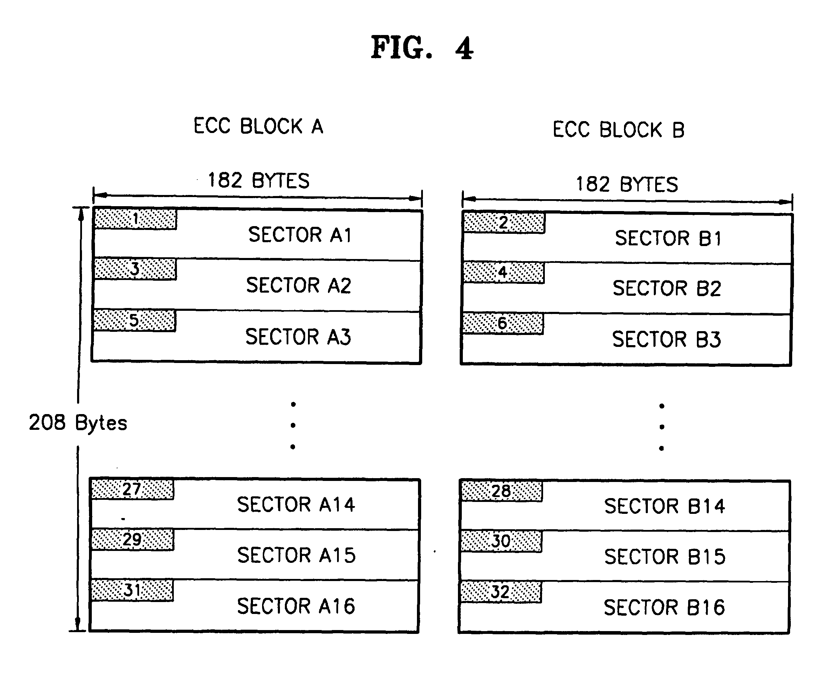

Figure 4 illustrates the format of ECC blocks A and B for interleaving according to the present invention. Referring to Figure 4, as described in Figures 2 and 3, the ECC block A consists of sector A1, . . , sector A16, and the ECC block B consists of sector B1, . . , sector B16. An identifier ID is included in each sector. Also, main data corresponding to the arranged identifier ID are arranged in each sector. In other words, the order of arrangement of the identifier ID is the same as the order of arrangement of the sector of the main data.

Assuming that the ECC blocks A and B are interleaved in the blocks, i.e. "between blocks interleaved" to generate one recording block, the order of arrangement of the identifier ID in the recording block is shown in Figure 4. In other words, the identifiers of the sectors included in the ECC blocks A and B are alternately and equally extracted and arrange so that the corresponding ECC blocks are alternately selected.
(1) Identifier of A1 ⇒ (2) Identifier of B1 ⇒ (3) Identifier of A2 ⇒ (4) Identifier of B2 ⇒ (5) Identifier of A3 ⇒ (6) Identifier of B3 ⇒, . . , ⇒ (31) Identifier of A16 ⇒ (32) Identifier of B16

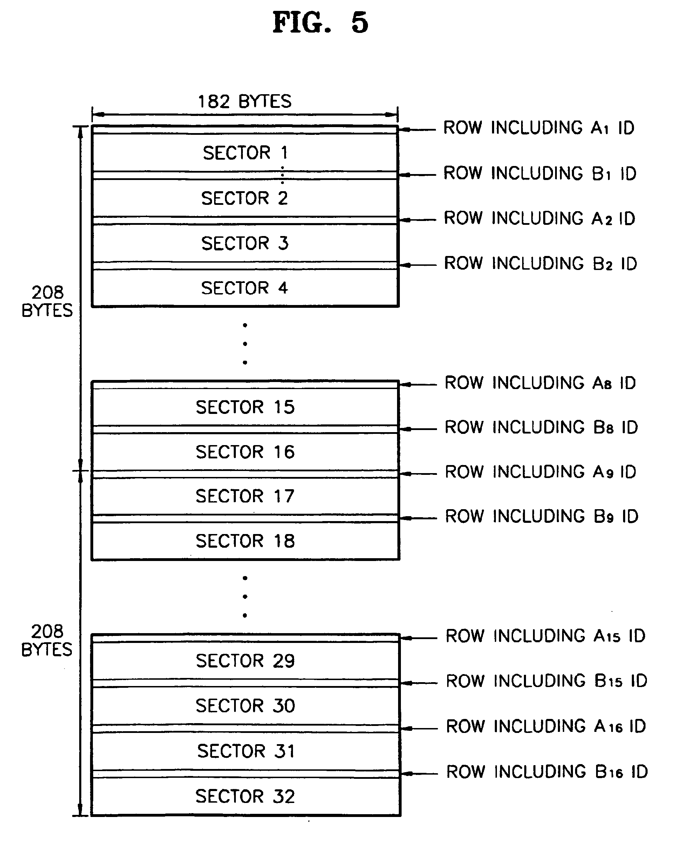

Figure 5 illustrates the format of a recording block according to the present invention. Referring to Figure 5, the recording block is obtained by interleaving in the block with the ECC blocks A and B of Figure 4. The recording block has a size of 208 × 2 bytes in a column direction and a size of 182 bytes in a row direction. New 32 sectors, which are generated by interleaving the 16 sectors (A1, . . , A16) included in the ECC block A of Figure 4 and the 16 sectors (B1, . . , B16) included in the ECC block B of Figure 4, are arranged in the recording block. In particular, a row-code word, in which the identifier ID of each sector is included, is in the first row of each sector. That is, the identifiers in the recording block are arranged in the order in which the identifiers of the sectors included in the ECC blocks A and B are alternately and equally extracted and arranged, as described with reference to Figure 4.

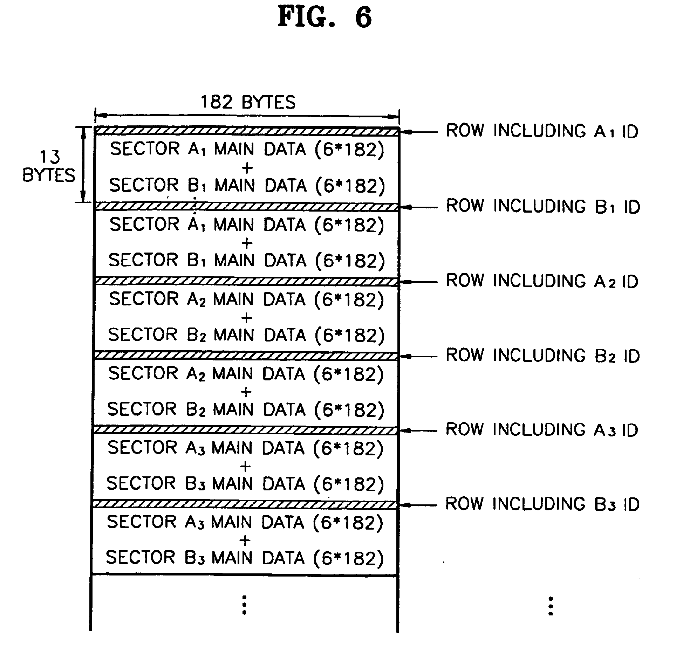

Figure 6 is an example of the recording block generated by interleaving of Figure 5 according to the present invention. Referring to Figure 6, a row-code word including an identifier ID, row-code words (ECC-encoded main data) included in the top half of the first sector A1 of the ECC block A, and row-code words (ECC-encoded main data) included in the top half of the first sector B1 of the ECC block B are interleaved in a first sector of the recording block. There are many interleaving methods. More specifically, the ECC-encoded main data can be interleaved in units of one or more rows, or in units of at least of part of the sectors.

Similarly, a row-code word including an identifier ID, row-code words (ECC-encoded main data) included in the bottom half of the first sector A1 of the ECC block A, and row-code words (ECC-encoded main data) included in the bottom half of the first sector B1 of the ECC block B are interleaved in a second sector of the recording block. The subsequent sectors are constituted by the same method.

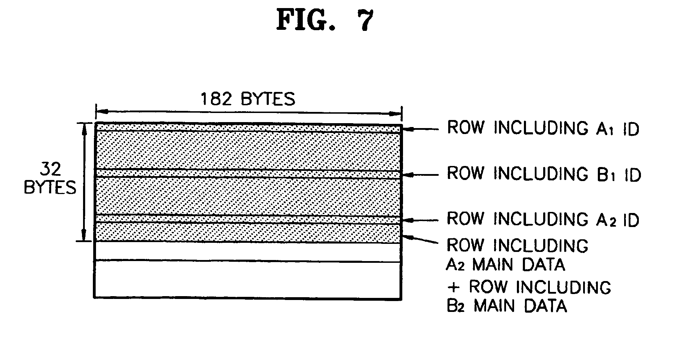

Figure 7 illustrates the largest error that can be corrected by error correction according to the present invention. Since each of the ECC blocks A and B can correct an error of each 16 bytes in a column direction, as shown in Figure 7, the largest error-generated range in which error correction is possible is a case where errors occur in 1 row including the identifier ID of a sector A1, 6 rows of the sector A1, 6 rows of a sector B1, 1 row including the identifier ID of the sector B1, the remaining 6 rows of the sector A1, the remaining 6 rows of the sector B1, 1 row including the identifier ID of a sector A2, 2 rows of the sector A2, and 3 rows of a sector B2. That is, for the ECC block A, errors occur in 1 + 6 + 6 + 1 + 2 = 16 rows, and for the ECC block B, errors occur in 6 + 1 + 6 + 3 = 16 rows. Thus, the sum of the rows in which errors occur is 32 rows. The size of data becomes 32 x 182 bytes.

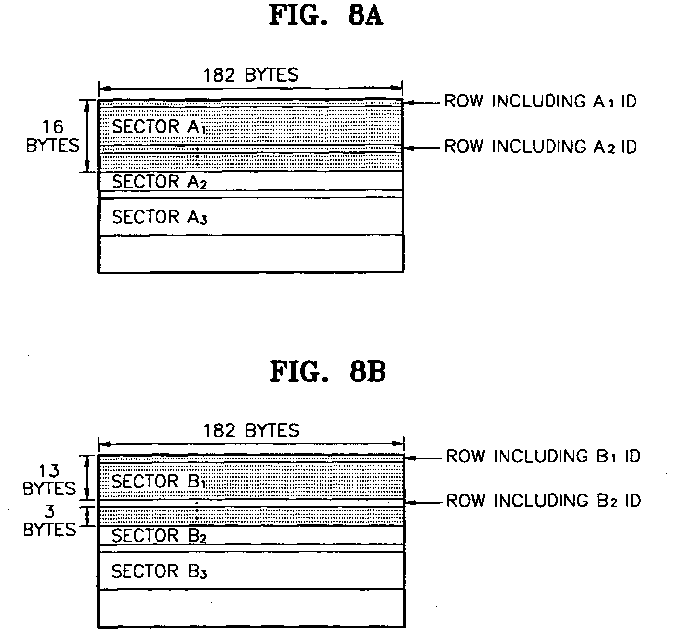

Figure 8 illustrates the recording block in which the largest error occurs, rearranged on the basis of the ECC blocks A and B of Figure 7. Figure 8A is a schematic view of the ECC block A which is generated by de-interleaving the recording block in which the largest error occurs, and Figure 8B is a schematic view of the ECC block B which is generated by de-interleaving the recording block in which the largest error occurs. The error occurring in the ECC block A is 16 bytes in total, and the error occurring in the ECC block B is also 16 bytes in total. That is, since each of the ECC blocks A and B can correct an error of each 16 bytes in a column direction, each error can be corrected.

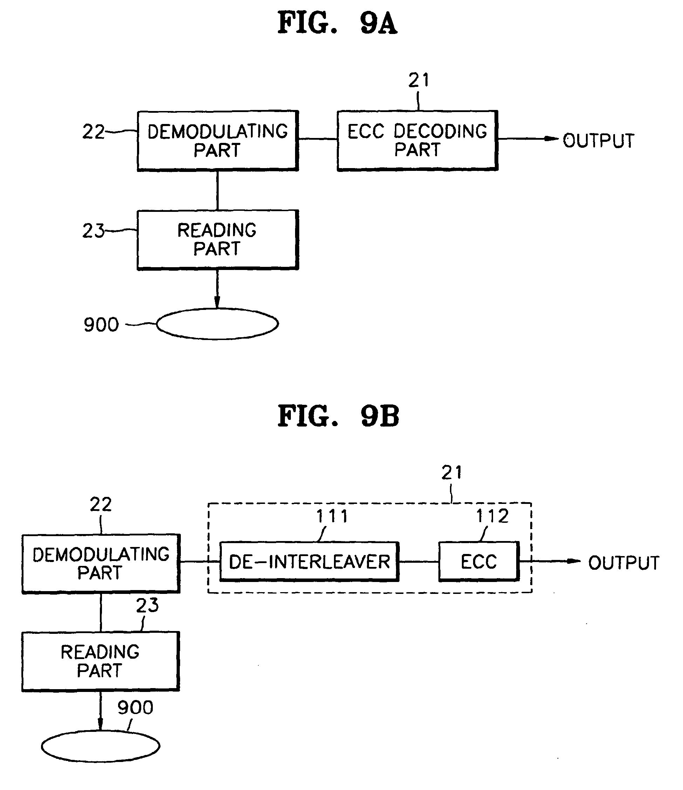

Figures 9A and 9B are block diagrams of a data reproducing apparatus according to the present invention. Referring to Figure 9A, the data reproducing apparatus includes a reading part 23, a demodulating part 22, and an ECC decoding part 21. The reading part 23 reads data from an optical disc 900 on which data are recorded according to the present invention. The demodulating part 22 demodulates the read data. The demodulating method used depends on the modulating method.

The ECC decoding part 21 ECC-decodes the demodulated data, that is, a recording block. More specifically, referring to Figure 9B, the ECC decoding part 21 includes a de-interleaver 111 and an ECC decoder 112. The de-interleaver 111 de-interleaves the recording block in the order reverse to the interleaver 12 of Figure 1B to generate a plurality of error correction code (ECC) blocks. The ECC decoder 112 decodes the demodulated data into main data with an ECC, which are used in the generated ECC block, and outputs the main data.

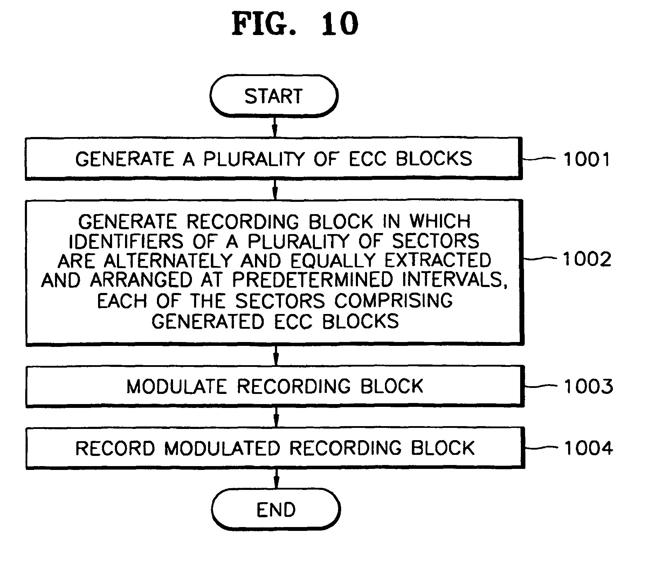

Figure 10 is a schematic flow chart illustrating a data recording method according to the present invention. Referring to Figure 10, in step 1001, an ECC encoder 11 ECC-encodes main data to generate a plurality of ECC blocks.

In step 1002, an interleaver 12 generates a recording block in which identifiers of a plurality of sectors are alternately and equally extracted and arranged at predetermined intervals, each of the sectors comprising generated ECC blocks. More specifically, identifiers in an ECC block and identifiers in the remaining ECC blocks are alternately and equally extracted and arranged at predetermined intervals in the recording block. The order of arrangement is decided such that the ECC blocks are alternately selected. The ECC-encoded main data included in the sectors corresponding to the arranged identifiers are interleaved to generate the recording block. Here, interleaving is performed in units of one or more rows, or in units of at least part of the sectors.

In step 1003, the modulating part 3 modulates the recording block. In step 1004, a recording part 5 records the modulated recording block on an optical disc 100.

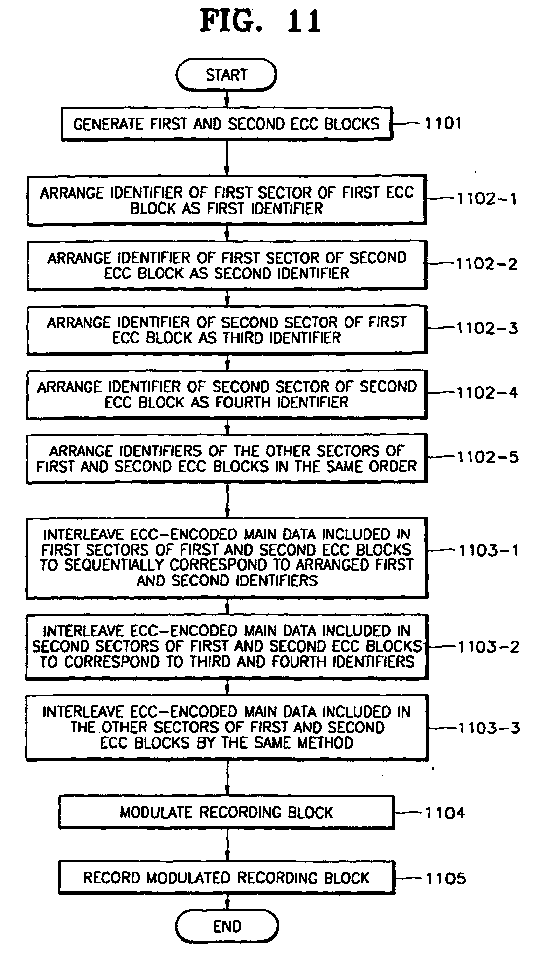

Figure 11 is a flow chart illustrating a data recording method according to the preferred embodiment of the present invention. Referring to Figure 11, in step 1101, the ECC encoder 11 ECC-encodes main data to generate first and second ECC blocks.

In step 1102-1, the interleaver 12 arranges an identifier of the first sector of the first ECC block as a first identifier, arranges an identifier of the first sector of the second ECC block as a second identifier in step 1102-2, arranges an identifier of the second sector of the first ECC block as a third identifier in step 1102-3, arranges the identifier of a second sector of the second ECC block as a fourth identifier in step 1102-4, and arranges identifiers of the remaining sectors of the first and second ECC blocks in the same order in step 1102-5. Here, the interleaver 12 interleaves the ECC-encoded main data included in the first sectors of the first and second ECC blocks to sequentially correspond to the arranged first and second identifiers in step 1103-1, interleaves the ECC-encoded main data included in the second sectors of the first and second ECC blocks to correspond to third and fourth identifiers in step 1103-2, and interleaves the ECC-encoded main data included in the remaining sectors of the first and second ECC blocks by the same method in step 1103-3, thereby generating the recording block.

In step 1104, the modulating part 3 modulates the recording block. In step 1105, the recording part 5 records the modulated recording block on the optical disc 100.

As described above, according to the present invention, the optical information recording medium, the data recording apparatus, and the data recording method used by the apparatus, which have higher error correction rates in recording/reading data, are provided. Further, according to the present invention, identifiers included in sectors are alternately and equally extracted and arranged in the recording block, thereby searching main data at a high speed together with lower error rates. Furthermore, according to the preferred embodiment of the present invention, an optical information recording medium, a data recording apparatus, and a data recording method used by the apparatus, which are compatible with the format of a conventional digital versatile disc (DVD) and have higher error correction rates, are provided.

While this invention has been particularly shown and described with reference to preferred embodiments thereof, it will be understood by those skilled in the art that various changes in form and details may be made therein without departing from the scope of the invention as defined by the appended claims.

## Claims

1. An optical information recording medium containing data included in one or more recording blocks, a recording block comprising a plurality of error correction code ECC blocks (A, B), wherein, for a recording block of the optical information recording medium, each of the plurality of ECC blocks (A,B) comprises a plurality of sectors (A1-A16, B1-B16) including corresponding identifiers (1-32);
**characterised in that** the identifiers (1-16) from a first said ECC block (A) are interleaved with identifiers (17-32) from at least a second said ECC block (B) in the recording block.

2. The medium as claimed in claim 1, wherein the recording blocks are modulated by a predetermined modulation method and recorded.

3. The medium as claimed in claim 1 or 2, wherein the identifiers (1-32) from the ones of the ECC blocks (A,B) are alternately and equally extracted and arranged at predetermined intervals, and ECC-encoded main data, which are included in the sectors (A1-A16,B1-B16) corresponding to the arranged identifiers, are interleaved.

4. The medium as claimed in claim 1, 2 or 3, wherein the ECC-encoded main data are interleaved in units of one or more rows.

5. The medium as claimed in claim 1, 2, 3 or 4, wherein the ECC-encoded main data are interleaved in units of at least a part of the sectors.

6. An optical information recording medium containing data included in one or more recording blocks, a recording block comprising a plurality of error correction code ECC blocks (A, B),
**characterised in that** for a recording block of the optical information recording medium:
an identifier (1) included in the first sector (A1) of a first ECC block (A) is arranged as a first identifier;
an identifier (2) included in the first sector (B1) of a second ECC block (B) is arranged as a second identifier;
an identifier (3) included in the second sector (A2) of the first ECC block (A) is arranged as a third identifier;
an identifier (4) included in the second sector (B2) of the second ECC block (B) is arranged as a fourth identifier;
identifiers included in the remaining sectors (A3-A16,B3-B16) of the first and second ECC blocks (A,B) are arranged with the same alternating pattern; and
ECC-encoded main data included in the first sectors (A1,B1) of the first and second ECC blocks are interleaved to sequentially correspond to the first arranged identifier (1) and the second arranged identifier (2), ECC-encoded main data included in the second sectors (A2, B2) of the first and second ECC blocks are interleaved to correspond to the third and fourth arranged identifiers (3,4), and ECC-encoded main data included in the remaining sectors (A3-A16,B3-B16) of the first and second ECC blocks (A,B) are interleaved with the same alternating pattern.

7. The medium as claimed in claim 6, wherein the recording blocks are modulated by a predetermined modulation method and recorded.

8. The medium as claimed in claim 6 or 7, wherein the identifiers (1-32) are alternately and equally extracted from the first and second ECC blocks (A,B) and arranged in one recording block at predetermined intervals.

9. The medium as claimed in claim 6, 7 or 8 wherein the ECC-encoded main data are interleaved in units of one or more rows.

10. The medium as claimed in claim 6, 7, 8 or 9 wherein the ECC-encoded main data are interleaved in units of at least a part of the sectors.

11. An apparatus for recording data on an optical information recording medium, the apparatus comprising:
an error correction code ECC encoder (11) which ECC-encodes main data to generate a plurality of ECC blocks, each ECC block comprising sectors and each sector having an identifier;
an interleaver (12) for generating a recording block from ones of the ECC blocks;
a modulating part (3) which modulates the generated recording block; and
a recording part (5) which records the modulated recording block;
**characterised in that** the interleaver (12) extracts and interlaves the identifiers (1-16) from a first said ECC block (A) with the identifiers (17-32) from at least a second said ECC block (B) to generate the recording block such that adjacent identifiers are of different ECC blocks.

12. The apparatus as claimed in claim 11, wherein the interleaver (12) alternately and equally extracts and arranges the identifiers (1-32) at predetermined intervals, and interleaves ECC-encoded main data included in the sectors (A1-A16,B1-B16) corresponding to the arranged identifiers.

13. The apparatus as claimed in claim 12, wherein the interleaver (12) performs the interleaving in units of one or more rows.

14. The apparatus as claimed in claim 12, wherein the interleaver (12) performs the interleaving in units of at least a part of the sectors.

15. An apparatus for recording data on an optical information recording medium, the apparatus comprising:
an error correction code ECC encoder (11) for ECC-encoding main data to generate first and second ECC blocks (A,B); each of the first and second ECC blocks comprises sectors and each sector includes an identifier;
an interleaver (12) for generating a recording block from ones of the ECC blocks;
a modulating part (3) which modulates the generated recording block; and
a recording part (5) which records the modulated recording block;
**characterised in that** for a recording block of the optical information recording medium the interleaver arranges an identifier (1) included in a first sector (A1) of the first ECC block (A) as a first identifier, arranges an identifier (2) included in a first sector (B1) of the second ECC block (B) as a second identifier, arranges an identifier (B) included in a second sector (A2) of the first ECC block (A) as a third identifier, arranges an identifier (4) included in a second sector (B2) of the second ECC block (B) as a fourth identifier, arranging identifiers included in the remaining sectors (A3-A16, B3-B16) of the first and second ECC blocks (A,B) with the same algorithm, interleaves ECC-encoded main data in the first sectors (A1,B1) of the first and second ECC blocks (A,B) to sequentially correspond to the first arranged identifier and the second arranged identifier, interleaves ECC-encoded main data in the second sectors (A2, B2) of the first and second ECC blocks (A,B) to correspond to the third and fourth arranged identifiers, and interleaves ECC-encoded main data included in the remaining sectors (A3-A16,B3-B16) of the first and second ECC blocks (A,B) with the same algorithm to generate the recording block.

16. The apparatus as claimed in claim 15, wherein the interleaver (11) alternately and equally extracts and arranges the identifiers at predetermined intervals.

17. The apparatus as claimed in claim 16, wherein the interleaver (11) performs the interleaving in units of one or more rows.

18. The apparatus as claimed in claim 16, wherein the interleaver (11) performs the interleaving in units of at least part of the sectors.

19. An optical information reproducing apparatus comprising:
a reading part (23) to read data from a recording block of an optical information recording medium, wherein ones of error correction code ECC blocks (A,B) are arranged in the recording block, each ECC block (A,B) including a plurality of sectors (A1-A16, B1-B16) having corresponding identifiers (1-32);
a demodulation part (22) to demodulate said read data; and
an ECC decoding part (21) to decode said de-modulated data;
**characterised in that** the reading part is arranged to read the identifiers from a first said ECC block (A) and a second said ECC block (B), in the recording block;
the identifiers (1-16) from the first said ECC block (A) being interleaved with identifiers (17-32) from at least a second said ECC block (B) in the recording block.

20. The optical information reproducing apparatus according to claim 19, wherein said ECC decoding unit comprises:
a de-interleaver (111) to de-interleave said recording block to generate a plurality of reproduced ECC blocks; and
an ECC decoder (112) to decode said demodulated data into main data with an ECC and to output said main data.

21. The optical information reproducing apparatus according to claim 19, wherein said demodulation is performed depending on the modulation of said recording block.

22. A computer readable medium encoded with instructions for implementing a method to record data on an optical information recording medium, performed by a computer, the method comprising:
error correction code (ECC) encoding main data to generate a plurality of ECC blocks (A,B), each ECC block (A,B) comprising a plurality of sectors (A1-A16,B1-B16) having corresponding identifiers (1-32);
generating a recording block from ones of the ECC blocks (A,B); and
recording the recording block on the optical information recording medium;
**characterised by** the recording block being generated by extracting and interleaving the identifiers (1-16) from a first said ECC block (A) with identifiers (17-32) from at least a second said ECC block such that adjacent identifiers are of different ECC blocks.

23. The computer readable medium according to claim 22, wherein said extracting and arranging of the identifiers (1-32) comprises:
alternately and equally extracting and arranging the identifiers (1-32) at predetermined intervals; and
interleaving ECC-encoded main data included in the sectors (A1-A16,B1-B16) corresponding to the arranged identifiers.

24. The computer readable medium according to claim 23, wherein said interleaving of the ECC-encoded main data is performed in units of one or more rows.

25. The computer readable medium according to claim 23, wherein said interleaving of the ECC-encoded main data is performed in units of at least a part of the sectors.

26. A computer readable medium encoded with instructions for implementing a method to reproduce data from an optical information recording medium, performed by a computer, the method comprising:
reading data from a recording block of the optical information recording medium, arranging ones of error correction code (ECC) blocks (A,B) in the recording block, each ECC block (A,B) comprising a plurality of sectors (A1-A16,B1-B16) having corresponding identifiers (1-32);
demodulating the read data; and
decoding the de-modulated data;
**characterised in that** in the reading step, identifiers are read from a first said ECC block and a second said ECC block, the identifiers (1-16) from a first said ECC block (A) being interleaved with identifiers (17-32) from at least a second said ECC block (B) in the recording block.

## Patentansprüche

1. Optisches Informationsaufzeichnungsmedium, das Daten enthält, die in einen Block oder mehrere Aufzeichnungsblöcke eingefügt sind, ein Aufzeichnungsblock eine Vielzahl von ECC-Blöcken (Fehlerkorrekturcode-Blöcken) (A, B) umfassend, wobei für einen Aufzeichnungsblock des optischen Informationsaufzeichnungsmediums jeder der Vielzahl von ECC-Blöcken (A, B) eine Vielzahl von Sektoren (A1 bis A16, B1 bis B16) umfasst, die entsprechende Kennungen (1 bis 32) enthalten,
**dadurch gekennzeichnet, dass** die Kennungen (1 bis 16) aus einem ersten ECC-Block (A) mit Kennungen (17 bis 32) aus wenigstens einem zweiten ECC-Block (B) in dem Aufzeichnungsblock verschachtelt sind.

2. Medium nach Anspruch 1, wobei die Aufzeichnungsblöcke durch ein vorgegebenes Modulationsverfahren moduliert werden und aufgezeichnet werden.

3. Medium nach Anspruch 1 oder 2, wobei die Kennungen (1 bis 32) alternierend und gleichmäßig aus den einzelnen ECC-Blöcken (A, B) extrahiert werden und in vorgegebenen Intervallen angeordnet werden und die ECC-codierten Hauptdaten, die in den Sektoren (A1 bis A16, B1 bis B16) entsprechend den angeordneten Kennungen enthalten sind, verschachtelt sind.

4. Medium nach Anspruch 1, 2 oder 3, wobei die ECC-codierten Hauptdaten in Einheiten von einer Reihe oder von mehreren Reihen verschachtelt werden.

5. Medium nach Anspruch 1, 2, 3 oder 4, wobei die ECC-codierten Daten in Einheiten von wenigstens einem Teil der Sektoren verschachtelt werden.

6. Optisches Informationsaufzeichnungsmedium, das Daten enthält, die in einen Block oder mehrere Aufzeichnungsblöcke eingefügt sind, ein Aufzeichnungsblock eine Vielzahl von ECC-Blöcken (Fehlerkorrekturcode-Blöcke) (A, B) umfassend,
**dadurch gekennzeichnet, dass** für einen Aufzeichnungsblock des optischen Aufzeichnungsmediums
eine Kennung (1), die in den ersten Sektor (A1) des ersten ECC-Blocks (A) eingefügt ist, als eine erste Kennung angeordnet ist,
eine Kennung (2), die in den ersten Sektor (B1) eines zweiten ECC-Blocks (B) eingefügt ist, als eine zweite Kennung angeordnet ist,
eine Kennung (3), die in den zweiten Sektor (A2) des ersten ECC-Blocks (A) eingefügt ist, als eine dritte Kennung angeordnet ist,
eine Kennung (4), die in den zweiten Sektor (B2) des zweiten ECC-Blocks (B) eingefügt ist, als eine vierte Kennung angeordnet ist,
Kennungen, die in die restlichen Sektoren (A3 bis A16, B3 bis B16) des ersten und des zweiten ECC-Blocks (A, B) eingefügt sind, mit demselben alternierenden Muster angeordnet sind und
ECC-codierte Hauptdaten, die in die ersten Sektoren (A1, B1) des ersten und des zweiten ECC-Blocks eingefügt sind, verschachtelt sind, um sequenziell der ersten angeordneten Kennung (1) und der zweiten angeordneten Kennung (2) zu entsprechen, ECC-codierte Hauptdaten, die in die zweiten Sektoren (A2, B2) des ersten und des zweiten ECC-Blocks eingefügt sind, verschachtelt sind, um der dritten und der vierten angeordneten Kennung (3, 4) zu entsprechen, und ECC-codierte Hauptdaten, die in die restlichen Sektoren (A3 bis A16, B3 bis B16) des ersten und des zweiten ECC-Blocks (A, B) eingefügt sind, mit demselben alternierenden Muster verschachtelt sind.

7. Medium nach Anspruch 6, wobei die Aufzeichnungsblöcke durch ein vorgegebenes Modulationsverfahren moduliert werden und aufgezeichnet werden.

8. Medium nach Anspruch 6 oder 7, wobei die Kennungen (1 bis 32) alternierend und gleichmäßig aus dem ersten und dem zweiten ECC-Block (A, B) extrahiert werden und in vorgegebenen Intervallen in einem Aufzeichnungsblock angeordnet werden.

9. Medium nach Anspruch 6, 7 oder 8, wobei die ECC-codierten Hauptdaten in Einheiten von einer Reihe oder von mehreren Reihen verschachtelt werden.

10. Medium nach Anspruch 6, 7, 8 oder 9, wobei die ECC-codierten Daten in Einheiten von wenigstens einem Teil der Sektoren verschachtelt werden.

11. Vorrichtung zum Aufzeichnen von Daten auf einem optischen Informationsaufzeichnungsmedium, die Vorrichtung umfasst:
einen Fehlerkorrekturcode-Codierer (ECC-Codierer) (11), der Hauptdaten ECCcodiert, um eine Vielzahl von EEC-Blöcken zu erzeugen, wobei jeder Block Sektoren umfasst und jeder Sektor eine Kennung hat,
einen Interleaver (12) zum Erzeugen eines Aufzeichnungsblocks aus einzelnen von den ECC-Blöcken,
einen Modulationsteil (3), der den erzeugten Aufzeichnungsblock moduliert,
einen Aufzeichnungsteil (5), der den modulierten Aufzeichnungsblock aufzeichnet, und
ist **dadurch gekennzeichnet, dass** der Interleaver (12) die Kennungen (1 bis 16) aus einem ersten ECC-Block (A) und die Kennungen (17 bis 32) aus wenigstens einem zweiten ECC-Block (B) extrahiert und diese miteinander verschachtelt, um den Aufzeichnungsblock so zu erzeugen, dass benachbarte Kennungen von verschiedenen ECC-Blöcken sind.

12. Vorrichtung nach Anspruch 11, wobei der Interleaver (12) die Kennungen (1 bis 32) alternierend und gleichmäßig extrahiert und diese in vorgegebenen Intervallen anordnet und die in die Sektoren (A1 bis A16, B1 bis B16) eingefügten Hauptdaten den angeordneten Kennungen entsprechend verschachtelt.

13. Vorrichtung nach Anspruch 12, wobei der Interleaver (12) die Verschachtelung in Einheiten von einer Reihe oder von mehreren Reihen durchführt.

14. Vorrichtung nach Anspruch 12, wobei der Interleaver (12) die Verschachtelung in Einheiten von wenigstens einem Teil der Sektoren durchführt.

15. Vorrichtung zum Aufzeichnen von Daten auf einem optischen Informationsaufzeichnungsmedium, die Vorrichtung umfasst:
einen Fehlerkorrekturcode-Codierer (ECC-Codierer) (11) zum ECC-Codieren von Hauptdaten, um erste und zweite ECC-Blöcke (A, B) zu erzeugen, wobei jeder von dem ersten und dem zweiten ECC-Block Sektoren umfasst und jeder Sektor eine Kennung enthält,
einen Interleaver (12) zum Erzeugen eines Aufzeichnungsblocks aus einzelnen von den ECC-Blöcken,
einen Modulationsteil (3), der den erzeugten Aufzeichnungsblock moduliert,
einen Aufzeichnungsteil (5), der den modulierten Aufzeichnungsblock aufzeichnet, und
ist **dadurch gekennzeichnet, dass** der Interleaver für einen Aufzeichnungsblock des optischen Informationsaufzeichnungsmediums eine Kennung (1), die in einen ersten Sektor (A1) des ersten ECC-Blocks (A) eingefügt ist, als eine erste Kennung anordnet, eine Kennung (2), die in einen ersten Sektor (B1) des zweiten ECC-Blocks (B) eingefügt ist, als eine zweite Kennung anordnet, eine Kennung (3), die in einen zweiten Sektor (A2) des ersten ECC-Blocks (A) eingefügt ist, als eine dritte Kennung anordnet, eine Kennung (4), die in einen zweiten Sektor (B2) des zweiten ECC-Blocks (B) eingefügt ist, als eine vierte Kennung anordnet, Kennungen, die in die restlichen Sektoren (A3 bis A16, B3 bis B16) des ersten und des zweiten ECC-Blocks (A, B) eingefügt sind, mit demselben Algorithmus anordnet, ECC-codierte Hauptdaten in den ersten Sektoren (A1, B1) des ersten und des zweiten ECC-Blocks (A, B) verschachtelt, um sequenziell der ersten angeordneten Kennung und der zweiten angeordneten Kennung zu entsprechen, ECC-codierte Hauptdaten in den zweiten Sektoren (A2, B2) des ersten und des zweiten ECC-Blocks (A, B) verschachtelt, um der dritten und der vierten angeordneten Kennung zu entsprechen, und ECC-codierte Hauptdaten, die in die restlichen Sektoren (A3 bis A16, B3 bis B16) des ersten und des zweiten ECC-Blocks (A, B) eingefügt sind, mit demselben Algorithmus verschachtelt, um den Aufzeichnungsblock zu erzeugen.

16. Vorrichtung nach Anspruch 15, wobei der Interleaver (12) die Kennungen alternierend und gleichmäßig extrahiert und diese in vorgegebenen Intervallen anordnet.

17. Vorrichtung nach Anspruch 16, wobei der Interleaver (12) die Verschachtelung in Einheiten von einer Reihe oder von mehreren Reihen durchführt.

18. Vorrichtung nach Anspruch 16, wobei der Interleaver (12) die Verschachtelung in Einheiten von wenigstens einem Teil der Sektoren durchführt.

19. Optische Informationswiedergabevorrichtung, umfassend:
einen Ausleseteil (23) zum Auslesen von Daten aus einem Aufzeichnungsblock eines optischen Informationsaufzeichnungsmediums, wobei einzelne von den Fehlerkorrekturcode-Blöcken (ECC-Blöcke) (A, B) in dem Aufzeichnungsblock angeordnet sind, jeder ECC-Block (A, B) eine Vielzahl von Sektoren (A1 bis A16, B1 bis B16) mit entsprechenden Kennungen (1 bis 32) enthält,
einen Demodulationsteil (22) zum Demodulieren der ausgelesenen Daten und
einen ECC-Decodierteil (21) zum Decodieren der demodulierten Daten,
**dadurch gekennzeichnet, dass** der Ausleseteil eingerichtet ist, um die Kennungen aus einem ersten ECC-Block (A) und aus einem zweiten ECC-Block (B) in dem Aufzeichnungsblock auszulesen, und
die Kennungen (1 bis 16) aus dem ersten ECC-Block mit den Kennungen (17 bis 32) aus wenigstens einem zweiten ECC-Block (B) in dem Aufzeichnungsblock verschachtelt sind.

20. Optische Informationswiedergabevorrichtung nach Anspruch 19, wobei die ECC-Decodiereinheit umfasst:
einen Deinterleaver (111), um den Aufzeichnungsblock Deinterleaving zu unterziehen, so dass eine Vielzahl von wiedergegebenen ECC-Blöcken erzeugt wird, und
einen ECC-Decoder (112), um die demodulierten Daten in Hauptdaten mit einem ECC zu decodieren und die Hauptdaten auszugeben.

21. Optische Informationswiedergabevorrichtung nach Anspruch 19, wobei die Demodulation in Abhängigkeit von der Modulation des Aufzeichnungsblocks durchgeführt wird.

22. Computerlesbares Medium, codiert mit Befehlen zum Implementieren eines Verfahrens zum Aufzeichnen von Daten auf einem optischen Informationsaufzeichnungsmedium, das durch einen Computer ausgeführt wird, wobei das Verfahren umfasst:
Fehlerkorrekturcode-Codieren (ECC-Codieren) der Hauptdaten, um eine Vielzahl von ECC-Blöcken (A, B) zu erzeugen, wobei jeder Block (A, B) eine Vielzahl von Sektoren (A1 bis A16, B1 bis B16) mit entsprechenden Kennungen (1 bis 32) aufweist,
Erzeugen eines Aufzeichnungsblocks aus einzelnen von den ECC-Blöcken (A, B) und
Aufzeichnen des Aufzeichnungsblocks auf dem optischen Informationsaufzeichnungsmedium,
**dadurch gekennzeichnet, dass** der Block erzeugt wird durch Extrahieren und Verschachteln der Kennungen (1 bis 16) aus einem ersten ECC-Block (A) mit Kennungen (17 bis 32) aus wenigstens einem zweiten ECC-Block so, dass benachbarte Kennungen von verschiedenen ECC-Blöcken sind.

23. Computerlesbares Medium nach Anspruch 22, wobei das Extrahieren und Anordnen der Kennungen (1 bis 32) umfasst:
alternierendes und gleichmäßiges Extrahieren und Anordnen der Kennungen (1 bis 32) in vorgegebenen Intervallen und
Verschachteln von ECC-codierten Hauptdaten, die in die Sektoren (A1 bis A16, B1 bis B16) eingefügt sind, entsprechend den angeordneten Kennungen.

24. Computerlesbares Medium nach Anspruch 23, wobei das Verschachteln der ECC-codierten Hauptdaten in Einheiten von einer Reihe oder von mehreren Reihen durchgeführt wird.

25. Computerlesbares Aufzeichnungsmedium nach Anspruch 23, wobei das Verschachteln der ECC-codierten Hauptdaten in Einheiten von wenigstens einem Teil der Sektoren durchgeführt wird.

26. Computerlesbares Aufzeichnungsmedium, codiert mit Befehlen zum Implementieren eines Verfahrens zur Wiedergabe von Daten von einem optischen Aufzeichnungsmedium, ausgeführt durch einen Computer, wobei das Verfahren umfasst:
Auslesen von Daten aus einem Aufzeichnungsblock des optischen Aufzeichnungsmediums, Einrichten einzelner Fehlerkorrekturcode-Blöcke (ECC-Blöcke) (A, B) in dem Aufzeichnungsblock, wobei jeder ECC-Block (A, B) eine Vielzahl von Sektoren (A1 bis A16, B1 bis B16) mit entsprechenden Kennungen (1 bis 32) enthält,
Demodulieren der ausgelesenen Daten und
Decodieren der demodulierten Daten,
**dadurch gekennzeichnet, dass** in dem Ausleseschritt Kennungen aus einem ersten ECC-Block und aus einem zweiten ECC-Block ausgelesen werden und die Kennungen (1 bis 16) aus einem ersten ECC-Block (A) mit Kennungen (17 bis 32) aus wenigstens einem zweiten ECC-Block (B) in dem Aufzeichnungsblock verschachtelt sind.

## Revendications

1. Support d'enregistrement d'informations optique contenant des données incluses dans un ou plusieurs blocs d'enregistrement, un bloc d'enregistrement comportant une pluralité de blocs de code de correction d'erreur ECC (A, B), dans lequel, pour un bloc d'enregistrement du support d'enregistrement d'informations optique, chaque bloc parmi la pluralité de blocs ECC (A, B) comporte une pluralité de secteurs (A1-A16, B1-B16) incluant des identifiants correspondants (1-32),
**caractérisé en ce que** les identifiants (1-16) dudit premier bloc ECC (A) sont entrelacés avec les identifiants (17-32) d'au moins ledit second bloc ECC (B) dans le bloc d'enregistrement.

2. Support selon la revendication 1, dans lequel les blocs d'enregistrement sont modulés par l'intermédiaire d'un procédé de modulation prédéterminé et enregistrés.

3. Support selon la revendication 1 ou 2, dans lequel les identifiants (1-32) des blocs ECC (A, B) sont extraits alternativement et de manière égale et agencés selon des intervalles prédéterminés, et des données principales soumises à un codage ECC, lesquelles sont incluses dans les secteurs (A1-A16, B1-B16) correspondant aux identifiants agencés, sont entrelacées.

4. Support selon la revendication 1, 2 ou 3, dans lequel les données principales soumises à un codage ECC sont entrelacées en unités d'une ou plusieurs rangées.

5. Support selon la revendication 1, 2, 3 ou 4, dans lequel les données principales soumises à un codage ECC sont entrelacées en unités d'au moins une partie des secteurs.

6. Support d'enregistrement d'informations optique contenant des données incluses dans un ou plusieurs blocs d'enregistrement, un bloc d'enregistrement comportant une pluralité de blocs de code de correction d'erreur ECC (A, B),
**caractérisé en ce que** pour un bloc d'enregistrement du support d'enregistrement d'informations optique :
un identifiant (1) inclus dans le premier secteur (A1) d'un premier bloc ECC (A) est agencé en tant que premier identifiant,
un identifiant (2) inclus dans le premier secteur (B1) d'un second bloc ECC (B) est agencé en tant que deuxième identifiant,
un identifiant (3) inclus dans le second secteur (A2) d'un premier bloc ECC (A) est agencé en tant que troisième identifiant,
un identifiant (4) inclus dans le second secteur (B2) d'un second bloc ECC (B) est agencé en tant que quatrième identifiant,
des identifiants inclus dans les secteurs restants (A3-A16, B3-B16) des premier et second blocs ECC (A, B) sont agencés selon le même modèle alternant, et
des données principales soumises à un codage ECC incluses dans les premiers secteurs (A1, B1) des premier et second blocs ECC sont entrelacées pour correspondre séquentiellement au premier identifiant agencé (1) et au deuxième identifiant agencé (2), des données principales soumises à un codage ECC incluses dans les seconds secteurs (A2, B2) des premier et second blocs ECC sont entrelacées pour correspondre aux troisième et quatrième identifiants agencés (3, 4), et des données principales soumises à un codage ECC incluses dans les secteurs restants (A3-A16, B3-B16) des premier et second blocs ECC (A, B) sont entrelacées selon le même modèle alternant.

7. Support selon la revendication 6, dans lequel les blocs d'enregistrement sont modulés par l'intermédiaire d'un procédé de modulation prédéterminé et enregistrés.

8. Support selon la revendication 6 ou 7, dans lequel les identifiants (1-32) sont extraits alternativement et de manière égale des premier et second blocs ECC (A, B) et agencés dans un bloc d'enregistrement selon des intervalles prédéterminés.

9. Support selon la revendication 6, 7 ou 8, dans lequel les données principales soumises à un codage ECC sont entrelacées en unités d'une ou plusieurs rangées.

10. Support selon la revendication 6, 7, 8 ou 9, dans lequel les données principales soumises à un codage ECC sont entrelacées en unités d'au moins une partie des secteurs.

11. Dispositif pour enregistrer des données sur un support d'enregistrement d'informations optique, le dispositif comportant :
un codeur ECC de code de correction d'erreur (11) qui soumet à un codage ECC des données principales pour générer une pluralité de blocs ECC, chaque bloc ECC comportant des secteurs et chaque secteur ayant un identifiant,
un entrelaceur (12) pour générer un bloc d'enregistrement depuis l'un des blocs ECC,
une partie de modulation (3) qui module le bloc d'enregistrement généré, et
une partie d'enregistrement (5) qui enregistre le bloc d'enregistrement modulé,
**caractérisé en ce que** l'entrelaceur (12) extrait et entrelace les identifiants (1-16) dudit premier bloc ECC (A) avec des identifiants (17-32) d'au moins ledit second bloc ECC (B) pour générer le bloc d'enregistrement de sorte que des identifiants adjacents sont de blocs ECC différents.

12. Dispositif selon la revendication 11, dans lequel l'entrelaceur (12) extrait alternativement et de manière égale et agence les identifiants (1-32) selon des intervalles prédéterminés, et entrelace des données principales soumises à un codage ECC incluses dans les secteurs (A1-A16, B1-B16) correspondant aux identifiants agencés.

13. Dispositif selon la revendication 12, dans lequel l'entrelaceur (12) exécute l'entrelacement en unités d'une ou plusieurs rangées.

14. Dispositif selon la revendication 12, dans lequel l'entrelaceur (12) exécute l'entrelacement en unités d'au moins une partie des secteurs.

15. Dispositif pour enregistrer des données sur un support d'enregistrement d'informations optique, le dispositif comportant :
un codeur ECC de code de correction d'erreur (11) pour soumettre à un codage ECC des données principales afin de générer des premier et second blocs ECC (A, B), chacun des premier et second blocs ECC comporte des secteurs et chaque secteur inclut un identifiant,
un entrelaceur (12) pour générer un bloc d'enregistrement depuis l'un des blocs ECC,
une partie de modulation (3) qui module le bloc d'enregistrement généré, et
une partie d'enregistrement (5) qui enregistre le bloc d'enregistrement modulé,
**caractérisé en ce que** pour un bloc d'enregistrement du support d'enregistrement d'informations optique, l'entrelaceur agence un identifiant (1) inclus dans un premier secteur (A1) du premier bloc ECC (A) en tant que premier identifiant, agence un identifiant (2) inclus dans un premier secteur (B1) du second bloc ECC (B) en tant que deuxième identifiant, agence un identifiant (3) inclus dans un second secteur (A2) du premier bloc ECC (A) en tant que troisième identifiant, agence un identifiant (4) inclus dans un second secteur (B2) du second bloc ECC (B) en tant que quatrième identifiant, en agençant des identifiants inclus dans les secteurs restants (A3-A16, B3-B16) des premier et second blocs ECC (A, B) à l'aide du même algorithme, entrelace des données principales soumises à un codage ECC dans les premiers secteurs (A1, B1) des premier et second blocs ECC (A, B) afin de correspondre séquentiellement au premier identifiant agencé et au deuxième identifiant agencé, entrelace des données principales soumises à un codage ECC dans les seconds secteurs (A2, B2) des premier et second blocs ECC (A, B) afin de correspondre aux troisième et quatrième identifiants agencés, et entrelace des données principales soumises à un codage ECC incluses dans les secteurs restants (A3-A16, B3-B16) des premier et second blocs ECC (A, B) à l'aide du même algorithme afin de générer le bloc d'enregistrement.

16. Dispositif selon la revendication 15, dans lequel l'entrelaceur (11) extrait alternativement et de manière égale et agence les identifiants selon des intervalles prédéterminés.

17. Dispositif selon la revendication 16, dans lequel l'entrelaceur (11) exécute l'entrelacement en unités d'une ou plusieurs rangées.

18. Dispositif selon la revendication 16, dans lequel l'entrelaceur (11) exécute l'entrelacement en unités d'au moins une partie des secteurs.

19. Dispositif de reproduction d'informations optique comportant :
une partie de lecture (23) pour lire des données à partir d'un bloc d'enregistrement d'un support d'enregistrement d'informations optique, certains des blocs de code de correction d'erreur ECC (A, B) étant agencés dans le bloc d'enregistrement, chaque bloc ECC (A, B) incluant une pluralité de secteurs (A1-A16, B1-B16) ayant des identifiants correspondants (1-32),
une partie de démodulation (22) pour démoduler lesdites données lues, et
une partie de décodage ECC (21) pour décoder lesdites données démodulées,
**caractérisé en ce que** la partie de lecture est agencée pour lire les identifiants dudit premier bloc ECC (A) et dudit second bloc ECC (B), dans le bloc d'enregistrement,
les identifiants (1-16) dudit premier bloc ECC (A) étant entrelacés avec les identifiants (17-32) d'au moins ledit second bloc ECC (B) dans le bloc d'enregistrement.

20. Dispositif de reproduction d'informations optique selon la revendication 19, dans lequel ladite unité de décodage ECC comporte :
un désentrelaceur (111) pour désentrelacer ledit bloc d'enregistrement afin de générer une pluralité de blocs ECC reproduits, et
un codeur ECC (112) pour décoder lesdites données démodulées en données principales avec un code ECC et pour délivrer en sortie lesdites données principales.

21. Dispositif de reproduction d'informations optique selon la revendication 19, dans lequel ladite démodulation est exécutée en fonction de la modulation dudit bloc d'enregistrement.

22. Support lisible par ordinateur codé à l'aide d'instructions pour mettre en oeuvre un procédé pour enregistrer des données sur un support d'enregistrement d'informations optique, exécuté par un ordinateur, le procédé comportant l'étape consistant à :
soumettre à un codage ECC des données principales pour générer une pluralité de blocs ECC (A, B), chaque bloc ECC (A, B) comportant une pluralité de secteurs (A1-A16, B1-B16) ayant des identifiants correspondants (1-32),
générer un bloc d'enregistrement depuis certains des blocs ECC (A, B), et
enregistrer le bloc d'enregistrement sur le support d'enregistrement d'informations optique,
**caractérisé en ce que** le bloc d'enregistrement est généré en extrayant et en entrelaçant les identifiants (1-16) dudit premier bloc ECC (A) avec des identifiants (17-32) d'au moins ledit second bloc ECC de sorte que des identifiants adjacents sont de blocs ECC différents.

23. Support lisible par ordinateur selon la revendication 22, dans lequel ladite extraction et ledit agencement des identifiants (1-32) comportent les étapes consistant à :
extraire alternativement et de manière égale et agencer les identifiants (1-32) selon des intervalles prédéterminés, et
entrelacer des données principales soumises à un codage ECC incluses dans les secteurs (A1-A16, B1-B16) correspondant aux identifiants agencés.

24. Support lisible par ordinateur selon la revendication 23, dans lequel ledit entrelacement des données principales soumises à un codage ECC est effectué en unités d'une ou plusieurs rangées.

25. Support lisible par ordinateur selon la revendication 23, dans lequel ledit entrelacement des données principales soumises à un codage ECC est exécuté en unités d'au moins une partie des secteurs.

26. Support lisible par ordinateur codé à l'aide d'instructions pour mettre en oeuvre un procédé afin de reproduire des données depuis un support d'enregistrement d'informations optique, exécuté par un ordinateur, le procédé comportant les étapes consistant à :
lire des données à partir d'un bloc d'enregistrement du support d'enregistrement d'informations optique, agencer certains des blocs de code de correction d'erreur (ECC) (A, B) dans le bloc d'enregistrement, chaque bloc ECC (A, B) comportant une pluralité de secteurs (A1-A16, B1-B16) ayant des identifiants correspondants (1-32),
démoduler les données lues, et
décoder les données démodulées,
**caractérisé en ce que**, à l'étape de lecture, des identifiants sont lus à partir dudit premier bloc ECC et dudit second bloc ECC, les identifiants (1-16) dudit premier bloc ECC (A) étant entrelacés avec les identifiants (17-32) d'au moins ledit second bloc ECC (B) dans le bloc d'enregistrement.
